# EUROPEAN PATENT SPECIFICATION

(11) **EP 2 940 808 B1**
(45) Date of publication and mention of the grant of the patent: **27.11.2019**
(21) Application number: 14166907.7
(22) Date of filing: 02.05.2014
(51) Int. Cl.: H01S 5/042, H01S 5/062, H01S 5/12, H01S 5/40

(54) **TIME-MULTIPLEXED DRIVING OF MULTI-COLOUR LASERS FOR QUASI-SIMULTANEOUS SPECTROSCOPIC ANALYSIS**
ZEITMULTIPLEX VON MEHRFARBIGEN FARBLASERN FÜR QUASISIMULTANE SPEKTROSKOPISCHE ANALYSE
COMMANDE MULTIPLEXÉE DANS LE TEMPS DE LASERS MULTICOLORES POUR L'ANALYSE SPECTROSCOPIQUE QUASI-SIMULTANÉE

(43) Date of publication of application: 04.11.2015
(73) Proprietor: EMPA Eidgenössische Materialprüfungs- und Forschungsanstalt, CH-8600 Dübendorf (CH)
(72) Inventor: Jágerská, jana, 8051 Zürich (CH); Mangold, Markus, 8004 Zürich (CH); Tuzson, Béla, 8600 Dübendorf (CH); Emmenegger, Lukas, 8600 Dübendorf (CH)
(74) Representative: Schmauder & Partner AG Patent- & Markenanwälte VSP

(56) References cited:
- WO-A1-2013/106619
- US-A1- 2008 025 359

## Description

### Technical field

The invention is related to time-multiplexed driving of multi-colour lasers for quasi-simultaneous spectroscopic analysis including a respective system and a method.

### Background of the invention

Simultaneous detection of multiple gas species using mid-infrared (MIR) laser spectroscopy is highly desired for numerous applications ranging from air quality monitoring, medical breath analysis, drug and explosive detection to industrial process control. Since it is often impossible to address the spectra of different gases with a single laser, state-of-the-art multi-color spectrometers have to rely on the use of several lasers with elaborate beam combining solutions. This makes them bulky, costly, and highly sensitive to optical alignment.

As a solution to this problem, multi-color MIR lasers such as Quantum Cascade Laser (QCL) or Interband Cascade Laser (ICL) based on a heterogeneous active region and concatenated distributed feedback (DFB) gratings of different periodicities on a single waveguide ridge were proposed. Respective disclosure is published in C. Gmachl, A. Straub, R. Colombelli, F. Capasso, D.L. Sivco, A.M. Sergent et al., "Single-mode, tunable distributed-feedback and multiple-wavelength quantum cascade lasers," IEEE J. Quantum Elect. 38, 569-581 (2002); R. Blanchard et al., "Gratings with an aperiodic basis: single-mode emission in multi-wavelength lasers," New J. Phys. 13, 113023 (2011); S. Höfling et al., "Controllable Switching Between Single Modes in Two-Segment Distributed Feedback Quantum Cascade Lasers," Proceedings of IEEE International Conference on Indium Phosphide and Related Materials, Princeton, USA, pp 23-25 (2006); and US 6148012 A by Capasso et al. Such lasers can emit light at several different wavelengths that inherently travel along the same optical path forming a single beam. As such, they don't require any beam combining optics and are ideal light sources for future multi-component trace gas spectrometers.

The reported multi-color lasers, however, were not able to operate at the multiple wavelengths sequentially, which strongly limited their application potential for laser spectroscopy. Simultaneous operation at several wavelengths leads to an overlap of the measured spectra and therefore to a cross-talk between the detected gas species. Sequential or time multiplex operation of multi-color lasers is in this sense a necessary prerequisite for their applicability in practical spectroscopy.

Electrical separation of concatenated DFB laser sections on a single waveguide and their sequential operation was treated on a theoretical level in WO-2013/106619 A1. However, the first practical demonstration actually leading to an individual control of two different emission wavelengths from one laser was demonstrated by J. Faist, "20 years of quantum cascade lasers: key steps and future promises," invited presentation at 20 years QCL Anniversary Workshop, available at http://www.multimedia.ethz.ch/conferences/2014/qcl/05_thursday. In US 2008/025539 A1 a directly modulated laser array with a microelectronic switch is disclosed.

### Description of the invention

According to a first aspect the invention has the object to provide a system including a driver for a multi-color laser enabling quasi-simultaneous detection of multiple gas species using MIR laser spectroscopy which assembly is applicable for numerous applications ranging from air quality monitoring, medical breath analysis, drug and explosive detection to industrial process control. According to a second aspect of the invention a method should be provided for quasi-simultaneous detection of multiple gas species.

The instant invention comprises a MIR multi-color laser such as a Quantum Cascade Laser (QCL) or Interband Cascade Laser (ICL) with concatenated and electrically separated laser sections driven for quasi-simultaneous detection of multiple gas species. Driving of the respective laser sections is time-division multiplexed, such that at a given time only one wavelength is emitted. A single laser driver combined with an electronic switch is used to multiplex the laser sections. The system and the method use an optimal switching rate, which needs to be determined for a given system.

Time division multiplexed driving essentially means, that the two or more laser sections of a multi-color laser are sequentially operated in time, *i.e.* at a given time, only one laser section is active, which allows detecting the gas species exhibiting absorption within the turning range of the given laser. When the measurement is completed, the first laser section is switched off and a different laser section is used to detect other gas species.

The object of the invention is solved by a system according to claim 1 and a method according to claim 5.

According to the setup of the instant invention as set forth in claim 1, an electronic switch is used which can distribute the driving current among the individual laser sections such that only one section is driven above the laser threshold and emits light, while all other sections are operated just below the threshold. Simultaneous driving of the non-active lasers below threshold minimizes the propagation loss of the lasing wavelength that gets otherwise reabsorbed in the unbiased active material.

Using one laser driver with a switch instead of two or more laser drivers hard wired to either laser section brings the following advantages: automatic synchronization of the driving pulses with the subthreshold pulses, reduced number of components for driving electronics - especially for a laser with three or more sections - resulting in a smaller footprint and lower cost for the whole system.

It is crucial to choose the right switching rate for optimal operation of the laser, which primarily depends on the driving mode of the laser including pulsed laser operation, intra-pulse operation, intermittent-Continuous Wave (iCW) operation and Continuous Wave (CW) operation.

### Pulsed lasers

Such lasers must be driven with very short pulses of typically 5-10 ns and are tuned using a subthreshold current ramp to scan the laser wavelength; the time to measure an absorption spectrum using a pulsed DFB laser (or one section of a pulsed multi-color laser) is typically 100 µs. The pulsed lasers exhibit low heat dissipation due to low duty cycle operation, but require radio-frequency compatible switches with rather long dead-times. There are several aspects to determine the optimal switching rate:
(i) An upper boundary for the switching rate is given by the time needed to record a single spectrum, e.g. 100 µs.
(ii) The radio-frequency compatible switches give rise to a dead-time (e.g. 300 µs), that must be added to (i). The relative effect of the dead time is reduced at lower switching rates that allow recording several spectra while the switch is in one position.
(iii) The first few spectra after switching taken with a given laser section (e.g. 300 µs) may need to be discarded since the laser takes time to get to the thermal equilibrium. Similarly to (ii), the relative effect is reduced at low switching rates.
(iv) Nonetheless, the switching rate should be much higher than the reaction time of the laser temperature controller. Since the heat dissipated in different laser sections may differ significantly, the thermo-electric controller (TEC) stabilizing the multi-color laser heat-sink tends to correct for the different heat dissipation at low switching rates. This produces spurious thermal chirp in the recorded spectra. At sufficiently high switching rates, the TEC senses the average heat dissipation and does not react to the change.
(v) The switching should be fast enough so that the data acquisition can be considered "quasi-continuous".

In pulsed operation, the interplay of aspects (ii), (iii), and (iv) leads to an optimal switching time of 10 ms during which spectra are taken, before the electronic switch selects the other laser section, and again, spectra are taken during 10 ms. This results in a complete measurement cycle of n^{∗}10 ms duration where n is the number of section of the laser.

### Intra-pulse operation

In intra-pulse operation, the laser is operated with pulses of 0.1 to 1 µs. The frequency of the iCW lasers is tuned by thermal chirp within the duration of the pulse, and a complete spectrum is measured during one pulse. Hence, the time to measure one absorption spectrum is on the order of 500 ns. The aspects (i)-(v) apply to intra-pulse operation just as to pulsed operation. Therefore, aspects (ii), (iii) and (iv) again result in an optimal switching time of approximately 10 ms.

### Intermittent-Continuous Wave (iCW) laser

iCW lasers are driven with long pulses of 2 to 200 µs duration and can be operated at high duty cycles of up to 50%. The frequency of the iCW lasers is tuned by thermal chirp within the duration of the pulse, and, hence, the time to measure one absorption spectrum is on the order of 1 µs. The switching hardware available for 100 µs pulses has much shorter death time than for pulsed lasers, being of the order of 1 µs, i.e. shorter than the time to record one spectrum.

When determining the optimal switching time, condition (ii) and (iii) don't apply and the optimal switching rate is determined by (i). In an iCW multi-wavelength experiment the optimal switching time is therefore given by the time to record a single spectrum.

### Continuous Wave (CW) lasers

In CW laser operation the laser is tuned with a current ramp at a typical rate of 1 to 10 kHz, and concerning the heat dissipation, switching hardware and times to record one single spectrum, they are analogous to the iCW lasers. The optimal switching rate is therefore also determined by condition (i).

Advantageous details in respect to the system and the method according to the instant invention are defined by the dependent claims.

The aforementioned elements as well as those claimed and described in the following exemplary embodiments, to be used according to the invention, are not subject to any particular conditions by way of exclusion in terms of their size, shape, use of material and technical design, with the result that the selection criteria known in the respective field of application can be used without restrictions. It should be noted that all means used to implement the invention are not limited to a particular design.

### Brief description of the drawings

Examples of the laser system and its operation will henceforth be described in more detail by reference to the drawings, wherein are shown:
- Figure 1: is a block diagram of the laser driving scheme according to a preferred embodiment of the instant invention;
- Figure 2: is a trigger and control signal routing for a typical application in MIR laser spectroscopy according to the embodiment of figure 1;
- Figure 3: is the driving scheme for a pulsed operation of the system of figures 1 and 2, shown in an embodiment with a three-color laser.
- Figure 4: shows the resulting current for the three sections of the embodiment of figure 3;
- Figure 5: is the driving scheme for an iCW operation of the system of figures 1 and 2, shown in an embodiment with a three-color laser.
- Figure 6: shows the resulting current for the three sections of the embodiment of figure 5;
- Figure 7: shows the diagram of the voltage and optimal power characteristic for an embodiment with a three color laser.

### Embodiments for carrying out the invention

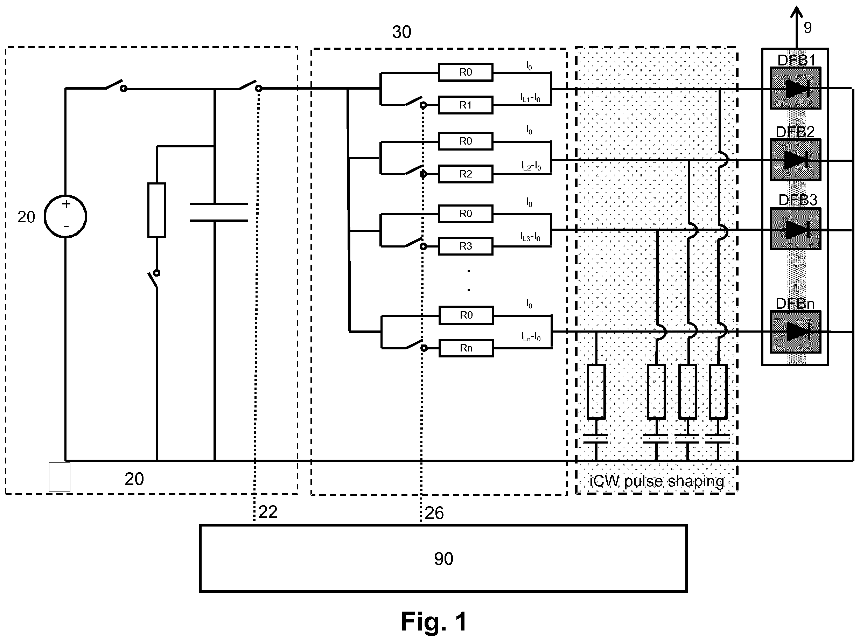

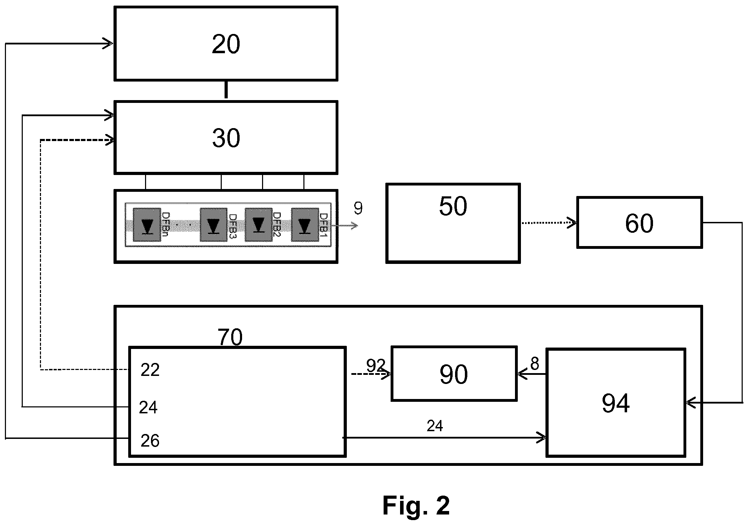

Figure 1 shows the laser driving scheme including one pulser 20, a multiplexing platform (laser selector unit) 30, a pulse shaping bloc - for iCW operation - and a multi-color DFB laser 94. The system is triggered and synchronized from a common CPU board 90 which CPU board's output includes a trigger signal output 22 and a switch control output 26. The switch control output according to the embodiment shown comprises an-n-channel control signal, wherein n is the number of laser sections of the system. The respective trigger and control signal routing is shown in figure 2. Figure 2 further shows the laser emission 9 the sample 50 is exposed with, the detector 60 to detect the radiation from the sample 50, the data acquisition unit 94 for the detector's output for outputting the signal 8 - in the embodiment shown a digital signal - for the computer board 90. The respective table of the switch control signal is shown in table 1:

**Table 1: Switch control signals used for n DFB's**

| **Laser ID** | Ch 1 | Ch 2 | Ch 3 | ... | Ch n |
|---|---|---|---|---|---|
| DFB 1 | 1 | **0** | **0** | **...** | **0** |
| DFB 2 | **0** | **1** | **0** | **...** | **0** |
| DFB 3 | **0** | **0** | **1** | **...** | **0** |
| ... | **...** | **...** | **...** | **...** | **...** |
| DFB n | **0** | **0** | **0** | **...** | **1** |

The respective Laser-ID signal for the DFB is signed as 92.

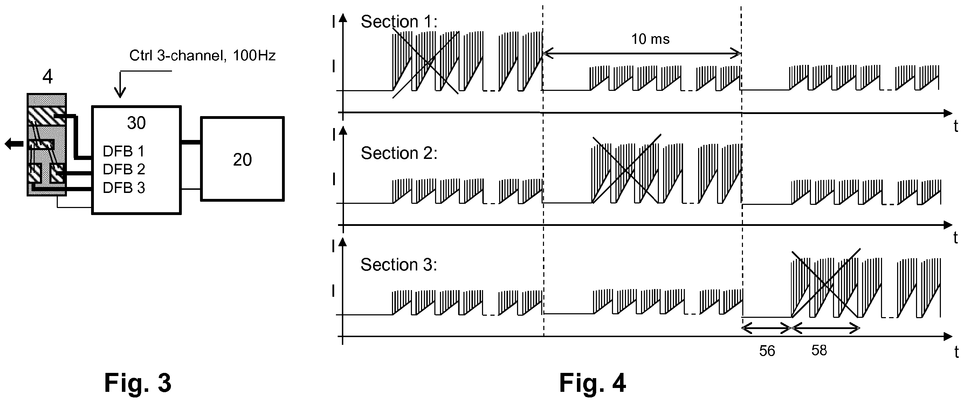

For pulsed operation a typical operation scheme is shown in figure 4 for a system with three laser sections. The parameters for a pulse duration of 5 to 10 ns and 100 averaged ramps of each 10 to 1000 µs duration - give a switch rate of 10 Hz to 1 kHz - with 100Hz in the current example - which depends also on the laser duty, the thermo-electric cooler (TEC) used and the switch dead time. In figure 4 the typical timing diagram is shown for the three sections, whereby one section is on duty only and after each switching event there is a switch dead time 56 and a thermal stabilization time 58 in which no measurement is meaningful. The diagram in figure 4 shows the laser sections 2 and 3 below the threshold in the first duty cycle in which only laser section 1 is lasing after the switch dead time

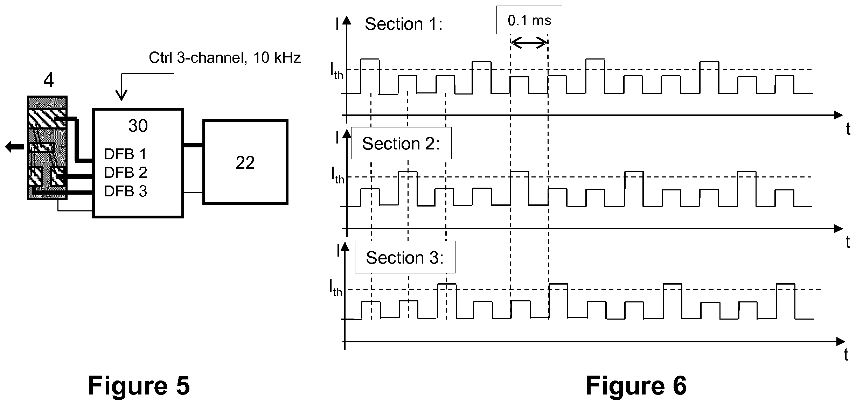

For Intermittent-Continuous Wave (iCW) operation a typical operation scheme is shown in figure 6, again for a system with three laser sections. The parameters for a pulse duration of 2 µs to 200 µs - dependent on the driver, the data acquisition and the laser - a duty of 1% to 50% - depending on the particular application and the power saving requirements - and a switch rate of 500 Hz to 250 kHz - with 10 kHz in the current example - depending on the laser duty, the thermo-electric cooler (TEC) used and the switch dead time. In figure 6 the typical timing diagram is shown for the three sections, whereby at a given time one section is on duty only.

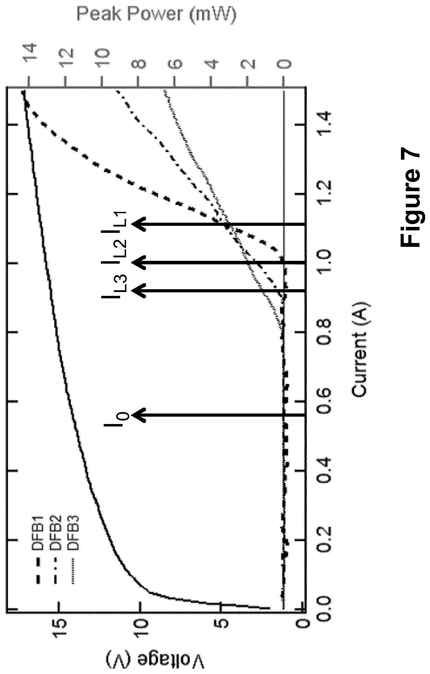

In figure 7 the voltage and optical output power characteristics for one embodiment with a laser having three laser sections are shown. The definition of the active (I_{L1}, I_{L2}, I_{L3}) and the subthreshold (I₀, identical for all DFBs) laser currents for this embodiment is related to the threshold currents I_{th_L1}, I_{th_L2} I_{th_L3} of the respective laser sections. The selected operation parameters are I_{L1} = 1.1 I_{th_L1}, I_{L2} = 1.1 I_{th_L2} and I_{L3}= 1.1 I_{th_L3} for the active laser current and I₀ = 0.7 min (I_{th_L1}, I_{th_L2} I_{th_L3}) for the subthreshold current.

### List of reference signs

- 4: Laser
- 8: Signal
- 9: Emission
- 20: Pulse generating means
- 22: Laser Trigger
- 26: Switch Control (n-channel)
- 30: Multiplex Platform/Laser selector unit
- 50: Sample
- 56: Switch dead time
- 58: Thermal stabilization time
- 60: Detector
- 70: Signal generator subsystem
- 90: CPU-board
- 92: Laser ID
- 94: Data acquisition subsystem

## Claims

1. A laser system for laser spectroscopy, including a mid-infrared, MIR, multi-color laser, laser driver means for said multi-color laser enabling simultaneous detection of a sample, preferably a multiple gas species, wherein said MIR multi-color laser comprises concatenated and electrically separated laser sections,
wherein said laser driver means comprise pulse generating means and are designed to drive the respective laser sections in a time-division multiplexed mode, such that the laser sections are sequentially operated in time and at a given time only one wavelength is emitted,
**characterized in that**
the laser driver means comprises a laser selector unit as a multiplexing platform and
an electronic switch is configured for distributing the driving current among the individual laser sections such that only one section is driven above the laser threshold and emits light, while all other sections are operated below the threshold.

2. The laser system according to claim 1 **characterized in that** said MIR multi-color laser is a Quantum Cascade Laser or Interband Cascade Laser.

3. The laser system according to claim 1 or 2, **characterized in that** the system further comprises detector means for detecting the laser radiation after passing the sample, data acquisition means for acquisition of the signals detected by the detector means and computer means for evaluating the data from the data acquisition means and providing a selection signal for the multiplexing of the laser selector unit.

4. The laser system according to claim 3, **characterized in that** the computer means is designed to further output a trigger signal triggering the pulse generating means.

5. A method for operation of a laser system for mid-infrared, MIR, laser spectroscopy, said laser system including a MIR multi-color laser, laser driver means for said multi-color laser, wherein said MIR multi-color laser comprises concatenated and electrically separated laser sections, wherein said laser driver means comprise pulse generating means and are designed to drive the respective laser sections in a time-division multiplexed mode, such that the laser sections are sequentially operated in time and at a given time only one wavelength is emitted, wherein the laser driver means comprises a laser selector unit, preferably a laser system according to any of claims 1 to 4, said method comprising
distributing the driving current among the individual laser sections such that only one section is driven above the laser threshold and emits light, while the other laser sections are operated below the threshold by means of said laser selector unit.

6. The method according to claim 5 **characterized in that** said MIR multi-colour laser is a Quantum Cascade Laser or Interband Cascade Laser.

7. The method according to claim 5 or 6, **characterized in that** detector means detecting the laser radiation after passing the sample, data acquisition means acquiring the signals detected by the detector means and computer means evaluating the data from the data acquisition means and outputting a selection signal for the multiplexing of the laser selector unit, thereby enabling simultaneous detection of a sample, preferably a multiple gas species.

8. The method according to claim 7, **characterized in that** the computer means further outputs a trigger signal triggering the laser.

9. The method according to any of claims 7 or 8 with a pulsed laser operation, **characterized in that** the pulse duration is in the range of 5 to 10 ns, a ramp in the range of 10 to 1000 µs, and the switch rate in the range of 10 Hz to 200 Hz, preferably about 100Hz whereby one section is on duty only and after switching events there is a switch dead time and a thermal stabilization time in which no measurement is performed.

10. The method according to any of claims 7 or 8 with an Intermittent-Continuous Wave operation, iCW, **characterized by** a pulse duration of 2 µs to 200 µs, a duty cycle of 1% to 50% and a switch rate of 500 Hz to 250 kHz, preferably of about 10 kHz.

11. The method according to claim 10 with an intra-pulse operation, **characterized in that** pulse duration is in the range of 0.1 to 1 µs, wherein the frequency of the iCW lasers is within the duration of the pulse, and preferably a complete spectrum is measured during one pulse.

12. The method of claim 11, **characterized in that** the switching time is approximately 10 ms.

13. The method according to any of claims 7 or 8 with a Continuous Wave operation, **characterized in that** the current ramp is in a range 1 to 10 kHz.

## Patentansprüche

1. Lasersystem für die Laserspektroskopie, umfassend einen Mittel-Infrarot MIR Mehrfarbenlaser und Lasertreibermittel für den besagten Mehrfarbenlaser, welches die gleichzeitige Erfassung einer Probe, vorzugsweise mehrerer Gasspezies, ermöglicht, wobei der besagte MIR Mehrfarbenlaser verkettete und elektrisch getrennte Lasersektionen umfasst,
wobei die besagten Lasertreibermittel Pulserzeugungsmittel umfassen und dazu ausgelegt sind, die jeweiligen Lasersektionen in einem Zeitscheiben-Multiplexmodus anzutreiben, sodass die Lasersektionen zeitlich sequentiell betrieben werden und zu einem gegebenen Zeitpunkt nur eine Wellenlänge emittiert wird,
**dadurch gekennzeichnet, dass**
die Lasertreibermittel eine Laserwähleinheit als Multiplexplattform umfassen und
ein elektronischer Schalter dazu konfiguriert ist, den Treiberstrom auf die einzelnen Laserabschnitte zu verteilen derart, dass nur eine Sektion oberhalb der Laserschwelle betrieben wird und Licht emittiert, während alle anderen Sektionen unterhalb der Schwelle betrieben werden.

2. Lasersystem nach Anspruch 1 **dadurch gekennzeichnet, dass** der besagte MIR Mehrfarbenlaser ein Quantenkaskadenlaser oder ein Interband-Kaskadenlaser ist.

3. Lasersystem nach Anspruch 1 oder 2, **dadurch gekennzeichnet, dass** das System weiterhin Detektormittel zur Detektion der Laserstrahlung nach dem Durchgang der Probe, Datenerfassungsmittel zum Erfassen der von den Detektormitteln detektierten Signale und Computermittel zum Auswerten der Daten der Datenerfassungsmittel und zum Bereitstellen eines Auswahlsignals für das Multiplexen der Laserwähleinheit umfasst.

4. Lasersystem nach Anspruch 3, **dadurch gekennzeichnet, dass** das Computermittel dazu ausgelegt ist, dass es weiterhin ein Auslösesignal ausgibt, welches das Pulserzeugungsmittel auslöst.

5. Verfahren zum Betreiben eines Lasersystems für die Mittel-Infrarot MIR Laserspektroskopie, wobei das besagte Lasersystem einen MIR Mehrfarbenlaser sowie Lasertreibermittel für den besagten Mehrfarbenlaser umfasst, wobei der besagte MIR Mehrfarbenlaser verkettete und elektrisch getrennte Lasersektionen umfasst, wobei die besagten Lasertreibermittel Pulserzeugungsmittel umfassen und dazu ausgelegt sind, die jeweiligen Lasersektionen in einem Zeitscheiben-Multiplexmodus anzutreiben, sodass die Lasersektionen zeitlich sequentiell betrieben werden und zu einem gegebenen Zeitpunkt nur eine Wellenlänge emittiert wird, wobei die Lasertreibermittel eine Laserselektionseinheit, vorzugsweise ein Lasersystem nach einem der Ansprüche 1 bis 4 umfasst, wobei das besagte Verfahren ein Verteilen des Treiberstroms auf die einzelnen Laserabschnitte umfasst derart, dass nur eine Sektion oberhalb der Laserschwelle betrieben wird und Licht emittiert, während alle anderen Sektionen unterhalb der Schwelle betrieben werden.

6. Verfahren nach Anspruch 5 **dadurch gekennzeichnet, dass** der besagte MIR Mehrfarbenlaser ein Quantenkaskadenlaser oder ein Interband-Kaskadenlaser ist.

7. Verfahren nach Anspruch 5 oder 6, **dadurch gekennzeichnet, dass** Detektormittel die Laserstrahlung nach dem Durchgang der Probe detektieren, Datenerfassungsmittel die von den Detektormitteln detektierten Signale erfassen und Computermittel die Daten der Datenerfassungsmittel auswerten und ein Auswahlsignal für das Multiplexen der Laserwähleinheit ausgeben, wodurch die gleichzeitige Erfassung einer Probe, vorzugsweise mehrerer Gasspezies, ermöglicht wird.

8. Verfahren nach Anspruch 7, **dadurch gekennzeichnet, dass** das Computermittel weiterhin ein Auslösesignal ausgibt, welches den Laser auslöst.

9. Verfahren nach einem der Ansprüche 7 oder 8 mit einem gepulsten Laserbetrieb, **dadurch gekennzeichnet, dass** die Pulsdauer im Bereich von 5 bis 10 ns liegt, eine Rampe im Bereich von 10 bis 1000 µs liegt, und die Umschaltrate im Bereich von 10 Hz bis 200 Hz liegt, vorzugsweise bei ungefähr 100 Hz, wobei nur eine Sektion in Betrieb ist und nach Schaltereignissen eine Schalttotzeit und eine thermische Stabilisierungszeit folgt, in der keine Messung durchgeführt wird.

10. Verfahren nach einem der Ansprüche 7 oder 8 mit einem intermittierendkontinuierlichen Wellenbetrieb, iCW, **gekennzeichnet durch** eine Impulsdauer von 2 µs bis 200 µs, ein Tastverhältnis von 1% bis 50% und eine Umschaltrate von 500 Hz bis 250 kHz, vorzugsweise von ungefähr 10 kHz.

11. Verfahren nach Anspruch 10 mit einem Intra-Puls-Betrieb, **dadurch gekennzeichnet, dass** die Pulsdauer im Bereich von 0.1 bis 1 µs liegt, wobei die Frequenz der iCW-Laser innerhalb der Pulsdauer liegt und vorzugsweise ein vollständiges Spektrum während eines Pulses gemessen wird.

12. Verfahren nach Anspruch 11, **dadurch gekennzeichnet, dass** die Umschaltzeit ungefähr 10 ms beträgt.

13. Verfahren nach einem der Ansprüche 7 oder 8 mit einem kontinuierlichen Wellenbetrieb, **dadurch gekennzeichnet, dass** die Stromrampe in einem Bereich von 1 bis 10 kHz liegt.

## Revendications

1. Système de laser destiné à la spectroscopie laser comprenant un laser infrarouge moyen MIR multicolore, des moyens de commande du laser multicolore permettant une détection simultanée d'un échantillon, de préférence de plusieurs espèces gazeuses, le laser MIR multicolore comprenant des sections de laser concaténées et séparées électriquement, les moyens de commande du laser comprenant des moyens de génération d'impulsions et étant conçus pour commander les sections de laser respectives selon un mode de multiplexage temporel de sorte que les sections du laser soient actionnées par séquences dans le temps et que, à un temps donné, une seule longueur d'ondes soit émise,
**caractérisé en ce que**
les moyens de commande du laser comprennent une unité de sélection de laser constituant une plateforme de multiplexage, et
un commutateur électronique est conformé pour distribuer le courant de commande parmi les sections de laser individuelles de sorte qu'une seule section soit commandée au-dessus du seuil d'émission laser et émette de la lumière alors que les autres sections sont actionnées au-dessous de ce seuil.

2. Système de laser conforme à la revendication 1,
**caractérisé en ce que**
le laser MIR multicolore est un laser à cascade quantique ou un laser à cascade interbandes.

3. Système de laser conforme à la revendication 1 ou 2,
**caractérisé en ce qu'**
il comporte en outre des moyens de détection permettant de détecter la radiation laser après qu'elle ait passé l'échantillon, des moyens d'acquisition de données permettant l'acquisition des signaux détectés par les moyens de détection et des moyens de calcul permettant d'évaluer les données provenant des moyens d'acquisition de données et de fournir un signal de sélection pour le multiplexage de l'unité de sélection du laser.

4. Système de laser conforme à la revendication 3,
**caractérisé en ce que**
les moyens de calcul sont conformés pour délivrer en outre en sortie un signal de déclenchement déclenchant les moyens de génération d'impulsions.

5. Procédé de gestion d'un système laser destiné à la spectroscopie laser infrarouge moyen MIR, ce système laser comprenant un laser MIR multicolore, des moyens de commande du laser multicolore, le laser MIR multicolore comprenant des sections de laser concaténées et séparées électriquement, les moyens de commande du laser comprenant des moyens de génération d'impulsion et étant conformés pour commander les sections de laser respectives selon un mode de multiplexage temporel de sorte que les sections du laser soient actionnées séquentiellement dans le temps et qu'à un temps donné une seule longueur d'onde soit émise, les moyens de commande du laser comprenant une unité de sélection de laser, de préférence d'un système de laser conforme à l'une quelconque des revendications 1 à 4,
ce procédé comportant une étape consistant à :
distribuer le courant de commande parmi les sections de laser individuelles de sorte qu'une seule section soit commandée au-dessus du seuil d'émission laser et émette de la lumière alors que les autres sections de laser sont actionnées au-dessous du seuil au moyen de l'unité de sélection laser.

6. Procédé conforme à la revendication 5,
**caractérisé en ce que**
le laser MIR multicolore est un laser à cascade quantique ou un laser à cascade interbandes.

7. Procédé conforme à la revendication 5 ou 6,
**caractérisé en ce que**
des moyens de détection détectent la radiation laser après qu'elle ait l'échantillon, des moyens d'acquisition de données reçoivent le signal détecté par les moyens de détection et des moyens de calcul évaluent les données provenant des moyens d'acquisition de données et délivrent en sortie un signal de sélection pour le multiplexage de l'unité de sélection laser permettant ainsi une détection simultanée d'un échantillon, de préférence de plusieurs espèces gazeuses.

8. Procédé conforme à la revendication 7,
**caractérisé en ce que**
les moyens de calcul délivrent en outre en sortie un signal de déclenchement déclenchant le laser.

9. Procédé conforme à l'une quelconque des revendications 7 ou 8, avec un fonctionnement de laser pulsé,
**caractérisé en ce que**
la durée d'impulsion est située dans la zone de 5 à 10 ns, la rampe est située dans la plage de 10 à 1000 µs, et le taux de commutation est situé dans la plage de 10 Hz à 200 Hz, de préférence égal à environ 100 Hz, une seule section est en service et après des événements de commutation il y a un temps mort de commutation et un temps de stabilisation thermique pendant lesquels aucune mesure n'est effectuée.

10. Procédé conforme à l'une quelconque des revendications 7 et 8, avec un fonctionnement par onde continue intermittente iCW,
**caractérisé par**
une durée d'impulsion de 2 µs à 200 µs, un cycle de service de 1% à 50% et un taux de commutation de 500 Hz à 250 kHz, de préférence d'environ 10 kHz.

11. Procédé conforme à la revendication 10, avec une opération d'impulsion interne,
**caractérisé en ce que**
la durée d'impulsion est située dans la plage de 0,1 à 1 µs, la fréquence du laser iCW est située dans la durée de l'impulsion et de préférence un spectre complet est mesuré pendant une impulsion.

12. Procédé conforme à la revendication 11,
**caractérisé en ce que**
la durée de commutation est égale à approximativement 10 ms.

13. Procédé conforme à l'une quelconque des revendications 7 et 8, avec un fonctionnement par onde continue,
**caractérisé en ce que**
la rampe du courant est située dans une plage de 1 à 10 kHz.
